# EUROPEAN PATENT APPLICATION

(11) **EP 3 437 798 A1**
(43) Date of publication of application: **06.02.2019**
(21) Application number: 17773604.8
(22) Date of filing: 27.01.2017
(51) Int. Cl.: B24B 37/24, B24B 37/22, B24D 11/00, H01L 21/304

(54) **POLISHING PAD AND POLISHING METHOD**

(30) Priority: 28.03.2016 JP 2016064313
(71) Applicant: Fujimi Incorporated, Kiyosu-shi, Aichi 452-8502 (JP)
(72) Inventor: ASAI, Maiko, Kiyosu-shi Aichi 452-8502 (JP); ITO, Yuuichi, Kiyosu-shi Aichi 452-8502 (JP); TAMAI, Kazusei, Kiyosu-shi Aichi 452-8502 (JP); TAHARA, Muneaki, Kiyosu-shi Aichi 452-8502 (JP)
(74) Representative: Grünecker Patent- und Rechtsanwälte PartG mbB
(86) International application number: PCT/JP2017/003016
(87) International publication number: WO 2017/169055

(57) **Abstract**

There is provided a polishing pad that ensures sufficiently performing polishing up to a part near a projection portion and an inner surface of a recessed portion in a surface of an object to be polished in polishing the object to be polished having a surface with at least one of the projection portion and the recessed portion. The polishing pad includes a napped part (1) where a plurality of fibers (12) with a length of 3 mm or more are napped on a surface of a base portion (11). A count of the fibers (12) is 10000 pieces/cm² or more.

## Description

### Technical Field

The present invention relates to a polishing pad and a polishing method.

### Background Art

While polishing an object to be polished with a projection portion on the surface using a conventional polishing pad constituted of, for example, suede can polish the most part of the surface of the object to be polished, deformability of the polishing pad is insufficient at a part near the projection portion in the surface of the object to be polished. Therefore, the polishing pad does not contact the part, and this sometimes failed to perform polishing sufficiently.

With the use of a fabric (for example, see PTL 1) including a napped part where fibers are napped as a polishing pad, since the napped part has high deformability, there is a possibility that the napped part contacts the part near the projection portion in the surface of the object to be polished as well. However, polishing using the fabric disclosed in PTL 1 as the polishing pad sometimes failed to sufficiently polish the part near the projection portion in the surface of the object to be polished depending on the shape and the size of the projection portion.

The same applies to the case of polishing an object to be polished with a recessed portion on the surface. The polishing using the conventional polishing pad constituted of suede and the polishing using the fabric disclosed in PTL 1 as the polishing pad sometimes failed to sufficiently polish the object to be polished up to the inner surface of the recessed portion.

### Citation List

### Patent Literature

PTL 1: JP 2010-53502 A

### Summary of Invention

### Technical Problem

Therefore, an object of the present invention is to provide a polishing pad and a polishing method that solve the above-described problems that the conventional art has and can sufficiently perform polishing up to a part near a projection portion and an inner surface of a recessed portion in a surface of an object to be polished in polishing the object to be polished having at least one of the projection portion and the recessed portion on the surface.

### Solution to Problem

To achieve the object, a polishing pad according to one aspect of the present invention has the following gist. The polishing pad includes a napped part where a plurality of fibers with a length of 3 mm or more are napped on a surface of a base portion. A count of the fibers is 10000 pieces/cm² or more.

A polishing method according to another aspect of the present invention has a gist of polishing an object to be polished using the polishing pad according to the one aspect.

### Advantageous Effects of Invention

According to present invention, polishing can be sufficiently performed up to a part near a projection portion and an inner surface of a recessed portion in a surface of an object to be polished in polishing the object to be polished having at least one of the projection portion and the recessed portion on the surface.

### Brief Description of Drawings

FIG. 1 is a drawing describing one embodiment of a polishing pad according to the present invention;
FIG. 2 is a drawing describing an object to be polished having a projection portion on the surface;
FIG. 3 is a drawing describing one embodiment of a polishing method according to the present invention, and is a drawing describing a method to polish the object to be polished having the projection portion on the surface;
FIG. 4 is a drawing describing an object to be polished having a recessed portion on the surface; and
FIG. 5 is a drawing describing one embodiment of a polishing method according to the present invention, and is a drawing describing a method to polish the object to be polished having the recessed portion on the surface.

### Description of Embodiments

One embodiment of the present invention will now be described in detail. Note that the following embodiments merely describe one example of the present invention, and the present invention is not limited to the embodiments. Various changes or improvements can be added to the following embodiments and the forms produced by adding such changes or improvements can be encompassed by the present invention.

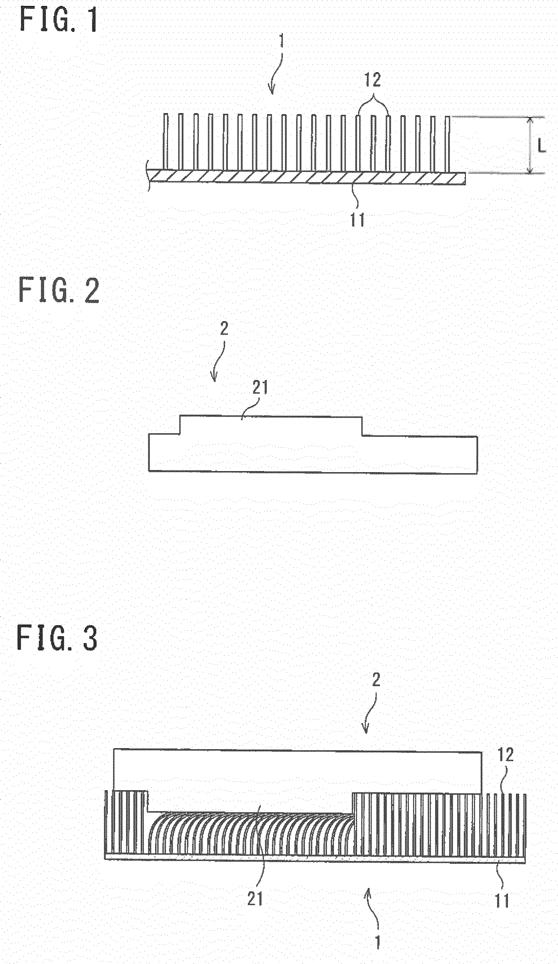

As illustrated in FIG. 1, a polishing pad of this embodiment includes a napped part 1 where a plurality of fibers 12 having a length L of 3 mm or more are napped on a surface of a base portion 11. A count of the fibers 12 having the length L of 3 mm or more napped on the surface of the base portion 11 is 10000 pieces/cm² or more.

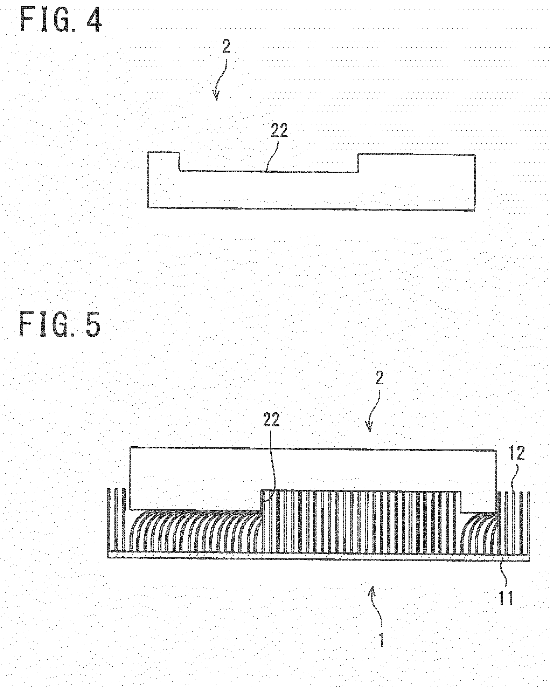

When an object to be polished 2 having a projection portion 21 on the surface as illustrated in FIG. 2 and the object to be polished 2 having a recessed portion 22 on the surface as illustrated in FIG. 4 is polished using a conventional polishing pad constituted of suede, nonwoven fabric, polyurethane, and the like, the shape of the polishing pad fails to follow the shapes of the projection portion 21 and the recessed portion 22 because deformability of the polishing pad is insufficient. The polishing pad does not contact a part (namely, a peripheral part of a base end portion of the projection portion 21) near the projection portion 21 and the inner surface of the recessed portion 22 in the surface of the object to be polished 2, and the polishing has failed in some cases.

However, when the object to be polished 2 having at least one of the projection portion 21 and the recessed portion 22 on the surface is polished using the polishing pad of this embodiment with the configuration as described above, the fibers 12 deform, the napped part 1 is depressed, and the napped part 1 follows the shapes of the projection portion 21 and the recessed portion 22. Accordingly, the polishing pad contacts the part near the projection portion 21 and the inner surface of the recessed portion 22 in the surface of the object to be polished 2 as well, thereby ensuring sufficient polishing. Therefore, the polishing pad of this embodiment is preferably usable for polishing the object to be polished 2 having at least one of the projection portion 21 and the recessed portion 22 on the surface. Additionally, the polishing pad of this embodiment is preferably usable for polishing the object to be polished 2 containing metal or a metal oxide material.

Furthermore, since the count of the fibers 12 is high density, 10000 pieces/cm² or more, precise polishing is possible compared with the case of the count being less than 10000 pieces/cm², ensuring a mirror finish of the surface of the object to be polished 2.

The suede is a material absent of a napped part and includes a foamed polyurethane layer having a large number of pores on a base material. This foamed polyurethane layer usually has a thickness of 1 mm or less and less than 2 mm at a maximum.

The following describes polishing pads, objects to be polished, polishing methods, and the like of the embodiments in further detail.

### (1) Polishing Pad

The length L of the fibers 12 is selectable according to the shapes and the sizes of the projection portion 21 and the recessed portion 22 such that the part near the projection portion 21 and the inner surface of the recessed portion 22 in the surface of the object to be polished 2 can be sufficiently polished.

With the length L of the fibers 12 of 3 mm or more (more preferably 5 mm or more), the deformability of the polishing pad becomes sufficient. Therefore, the polishing pad deforms following the projection portions 21 and the recessed portions 22 with various shapes and sizes, and the part near the projection portion 21 and the inner surface of the recessed portion 22 in the surface of the object to be polished 2 can be sufficiently polished. The short length L of the fibers 12 results in insufficient following capability (deformability) of the polishing pad to the shapes of the projection portion 21 and the recessed portion 22 on the object to be polished 2, possibly deteriorating surface roughness and a glossiness of the surface of the object to be polished 2 after the polishing. Meanwhile, the fibers 12 preferably have the length L of 10 mm or less and more preferably 7 mm or less. The length L of the fibers 12 in the range facilitates installing the polishing pad to a polishing device, and the fibers 12 of the polishing pad are less likely to tangle with the polishing device during the polishing. Additionally, a production cost of the polishing pad is reduced.

The length L of the fibers 12 napped on the surface of the base portion 11 may be 5.5 times or more of the height of the projection portion 21 or the depth of the recessed portion 22. Since the length of the fibers 12 napped on the surface of the base portion 11 becomes the size sufficiently large relative to the height of the projection portion 21 or the depth of the recessed portion 22 with such configuration, the deformability of the polishing pad is further increased. Accordingly, the polishing pad sufficiently deforms following the projection portion 21 and the recessed portion 22; therefore, the part near the projection portion 21 and the inner surface of the recessed portion 22 in the surface of the object to be polished 2 can be further sufficiently polished. The length L of the fibers 12 napped on the surface of the base portion 11 is more preferable to be seven times or more of the height of the projection portion 21 or the depth of the recessed portion 22.

The length L of the fibers 12 is selected by the height of the projection portion 21 and the depth of the recessed portion 22. For example, in the case where the height of the projection portion 21 and the depth of the recessed portion 22 are large, 1 mm or more, the longer the length L of the fibers is preferable, 5.5 mm or more. In the case where the height of the projection portion 21 and the depth of the recessed portion 22 are small, such as 0.5 mm or less, the length L of the fibers may be short, such as 3 mm or more. The length of the fibers napped on the surface of the base portion 11 may all have an identical length, or the fibers of different lengths may be mixed. While the fibers napped on the surface of the base portion 11 may be only the fibers 12 with the length L of 3 mm or more, the fibers may be both of the fibers 12 with the length L of 3 mm or more and the fibers with the length L of less than 3 mm.

Furthermore, the count of the fibers 12 napped on the surface of the base portion 11 with the length L of 3 mm or more is 10000 pieces/cm² or more and more preferably 12000 pieces/cm² or more. With the count of the fibers 12 napped on the surface of the base portion 11 with the length L of 3 mm or more of 10000 pieces/cm² or more, the amount (the density) of the long fibers 12 becomes sufficient. This makes it possible to sufficiently polish the part near the projection portion 21 and the inner surface of the recessed portion 22 in the surface of the object to be polished 2. Additionally, the surface roughness and the glossiness of the surface of the object to be polished 2 after the polishing become sufficiently excellent. Meanwhile, the count of the fibers 12 napped on the surface of the base portion 11 with the length L of 3 mm or more is preferably 25000 pieces/cm² or less and more preferably 20000 pieces/cm² or less. With the count of the fibers 12 in the range, since heat generated during the polishing is less likely to be accumulated to the polishing pad, a rise of a polishing temperature can be reduced.

The fibers 12 may be installed to the base portion 11 separately one by one. A plurality of the fibers 12 may be bundled to produce a bundled product or a plurality of the fibers 12 may be twisted to produce a string-shaped product, and a plurality of the bundled products or the string-shaped products may be installed to the base portion 11. Twisting the plurality of fibers increases the strength and therefore the polishing removal rate is improved, and when the plurality of fibers are not twisted, a count of contacts to the object to be polished by the fibers increases; therefore, there may be a case where the surface roughness of the object to be polished after the polishing becomes more excellent and the glossiness increases. To install the bundled products or the string-shaped products to the base portion 11, the count of the fibers 12 does not mean the count of bundled products and string-shaped products but means the count of the fibers 12.

While the thickness of the fibers 12 is not especially limited, 50 µm or less is preferable, 30 µm or less is more preferable, and 20 µm or less is further preferable. The thinned fibers 12 are less likely to damage the object to be polished 2 and the scratch is less likely to be generated; therefore, a mirrored surface is easily obtainable. The thinned fibers 12 further easily follow the shapes of the projection portion 21 and the recessed portion 22 on the object to be polished 2. Meanwhile, the fibers 12 preferably have the thickness of 10 µm or more and more preferably 12 µm or more. The excessively thinned fibers 12 weaken polishing force and possibly fail to obtain the sufficient polishing removal rate. The thickened fibers 12 are excellent in resistance to polishing and less likely to abrade away, and possibly lengthen a life as the polishing cloth. While the thicknesses of the fibers 12 may be uniform across the entire fibers 12 in the longitudinal direction, the thicknesses need not to be uniform. The fibers 12 having different thicknesses between the roots and the distal ends, for example, the distal ends of the fibers 12 being thin, thick, and rounded are acceptable.

Furthermore, while the mass of the fibers 12 napped on the surface of the base portion 11 with the length L of 3 mm or more is not especially limited, 200 g/m² or more is preferable and 250 g/m² or more is more preferable. With the mass of the fibers 12 in the range, the amount of the long fibers 12 becomes sufficient; therefore, the part near the projection portion 21 and the inner surface of the recessed portion 22 in the surface of the object to be polished 2 can be sufficiently polished. Additionally, the following capability (the deformability) of the polishing pad relative to the shapes of the projection portion 21 and the recessed portion 22 on the object to be polished 2 becomes sufficient. Meanwhile, the mass of the fibers 12 napped on the surface of the base portion 11 with the length L of 3 mm or more is preferably 1000 g/m² or less and more preferably 700 g/m² or less. The mass of the fibers 12 in the range reduces the production cost of the polishing pad.

The material of the base portion 11 is not especially limited, and a cloth such as a nonwoven fabric, a natural material such as a linen, resin such as rubber, and the like are applicable.

The kind of the fibers 12 is not especially limited, and natural fiber such as wool, silk, linen, cotton, horsehair, hog bristle, goat hair, vera hair, tampico, palm, fern, and the like, synthetic fiber such as polyester (such as polyethylene terephthalate, polytrimethylene terephthalate, polybutylene terephthalate, polyethylene naphthalate, polybutylene naphthalate, and polylactic acid), polyamide (such as nylon and aramid), polyimide, polyvinyl alcohol, polyolefin (such as polyethylene, ultra high molecular weight polyethylene, polyethylene multifilament, and polypropylene), rayon, polyurethane, polyacrylate, polyparaphenylene benzobisoxazole, polyphenylene sulfide, and fluororesin (such as polyvinylidene fluoride), metallic fiber, carbon fiber, and the like are applicable. One kind of these fibers may be used alone or two or more kinds of the fibers may be used in combination.

The wool is preferable among the natural fibers because of the high strength. However, considering the feature that the fibers 12 are less likely to come off from the base portion 11 (such as durability), the synthetic fiber is less likely to come off compared with the natural fiber; therefore, the synthetic fiber is preferable, and among them, nylon, polyester, polyolefin, and aramid are further preferable.

The fibers 12 may contain or kind or more selected from a micropore forming agent, a dye, a coloring inhibitor, a heat stabilizer, a fluorescent brightener, a delusterant, a colorant, a dehumidifying agent, inorganic particulates, abrasives, and resin as necessary within the scope of not losing the object of the present invention.

Furthermore, while the shape of the fibers 12 is not especially limited, linearly-extending fibers, fibers with a wave shape, loop-shaped fibers (one fiber is bent to form an approximately elliptical shape or an approximately inverse U-shape, and the fibers are installed to the base portion 11 such that the parts curved into an acute angle come to the distal ends), and the like are applicable. With the linearly-extending fibers and the fibers with the wave shape, the polishing removal rate becomes high when corner portions are formed at the distal ends, and the object to be polished is less likely to be scratched when the distal ends are formed roundly. Since the loop-shaped fibers have the rounded distal ends, the object to be polished is less likely to be scratched.

However, from an aspect that because of many contact points by point contact with the object to be polished, a count of contacts with the object to be polished increases and there may be a case where the surface roughness of the object to be polished after the polishing becomes excellent and the glossiness increases, the linearly-extending fibers and the fibers with the wave shape are preferable compared with the loop-shaped fibers. The linearly-extending fibers or the fibers with the wave shape whose distal ends are not twisted and have the shape detangled into clusters are further preferable. Since the loop-shaped fibers linearly contact the object to be polished, the contact area widens and the polishing removal rate is improved in some cases. Since the loop-shaped fibers have a cushioning property due to the shape, the fibers are less likely to fall over in some cases. However, since the loop-shaped fibers have high friction, the surface roughness of the object to be polished after the polishing is possibly deteriorated compared with the linearly-extending fibers and the fibers with the wave shape.

The cross-sectional shape of the fibers 12 is not especially limited, the shape may be a circular shape, an oval shape, a polygonal shape (a triangular shape, a quadrangular shape, a pentagonal shape, a hexagonal shape, and the like), a flat shape (a linear shape), a hollow (the count of hollow portions is not especially limited, may be one or may be plural), and the like. Alternatively, the cross-sectional shape of the fibers 12 may be a C shape, an H shape, an I shape, an L shape, an N shape, an S shape, a T shape, an U shape, a V shape, a W shape, an X shape, a Y shape, a star shape (as long as three or more, a count of sides of the star shape may be any count), and the like.

Further, the cross-sectional shape of the fibers 12 may be a shape in which fin portions radially extend from an outer periphery of a circular or a polygonal core portion (may be a hollow) or a shape in which fin portions radially extend from the center point. A count of the fin portions is not especially limited and may be one or may be plural. The shape of the fin portions is not especially limited and includes a linear shape, a curved line shape, a bent line shape, and a branched line shape.

Further, the cross-sectional shape of the fibers 12 may have a shape of a combination of a plurality of (for example, two pieces or three pieces) unit parts (that is, a shape divided into a plurality of parts). The plurality of unit parts may all have an identical cross-sectional shape or may have different cross-sectional shapes. The cross-sectional shape of the unit parts is not especially limited, and the respective cross-sectional shapes listed above as the cross-sectional shapes of the fibers 12 are applicable. For example, the cross-sectional shape of the fibers 12 may be a shape of a combination of a plurality of unit parts such as a C-shaped, V-shaped, Y-shaped, and Z-shaped cross-sectional shapes.

Regarding the shape of the distal ends of the fibers 12, the distal ends of all fibers may have an identical shape or the fibers having the different distal end shapes may be mixed.

Furthermore, the surface of the fibers 12 may be a flat shape or may have unevenness.

Furthermore, the fibers 12 may be installed to the base portion 11 separately one by one. A plurality of the fibers 12 may be bundled to produce a bundled product or a plurality of the fibers 12 may be twisted to produce a string-shaped product, and a plurality of the bundled products or the string-shaped products may be installed to the base portion 11.

A carpet is applicable as such polishing pad of this embodiment. The kind of the carpet is not especially limited, and a carpet manufactured by using a method such as a weaving, embroidery, bonding, knitting, compression, or flocking is applicable. The carpet manufactured with the fabric includes a machine-woven carpet such as a tufted carpet, a Wilson weaving, a Jacquard weaving, and an Axminster carpet, and a hand woven carpet such as a Chinese cotton carpet and a Pakistan carpet. The carpet manufactured by embroidery includes a hooked rug and the like. The carpet manufactured by bonding includes a bonded carpet and the like. The carpet manufactured by knitting includes a knitted carpet and the like. The carpet manufactured by compression includes a needle punched carpet and the like. The carpet manufactured by flocking includes an electrostatic flocking carpet and the like.

Alternatively, one manufactured by flocking fibers on a pedestal (a base portion) like a brush is applicable as the polishing pad of this embodiment. The flocking method is not especially limited and may be produced by forming holes on the pedestal, inserting one ends of the fibers into the holes, and pinning and fixing the fibers with pins made of metal or made of resin or bonding and fixing the fibers by heat and adhesive.

The polishing pad of this embodiment may have a multilayer structure where an elastic layer made of an elastic body is disposed, on a side opposite to a side where the fibers 12 are napped, on the base portion 11. Describing with reference to FIG. 1, the elastic layer (not illustrated) made of the elastic body may be stacked on the principal surface on the side opposite to the side where the fibers 12 are napped among the two principal surfaces that the sheet-shaped base portion 11 has. Disposing the elastic layer improves the following capability (the deformability) of the polishing pad to the shapes of the projection portion 21 and the recessed portion 22 on the object to be polished 2.

Examples of the elastic body include a sponge formed of resin foam through foaming resin such as polyurethane, polyvinyl chloride, chloroprene rubber, ethylene/propylene rubber, butyl rubber, polybutadiene, polyisoprene, EPDM polymer, ethylene-vinyl acetate, neoprene, melamine, polyethylene, and styrene/butadiene copolymer.

The count of cells, the compression ratio to the original thickness, the shape, and the density of the resin before the foaming of the sponge are not especially limited and may be selected appropriately according to the application of the polishing pad and the like.

The elastic layer may be constituted of the sponge alone or may be constituted in combination with another material such as a cushion material and a reinforcing agent as necessary.

While the thickness of the elastic layer is not especially limited, 0.1 mm or more is preferable and 1 mm or more is more preferable. The thin elastic layer possibly fails to develop the sufficient cushioning property. The elastic layer preferably has the thickness of 20 mm or less and more preferably 15 mm or less. The thick elastic layer possibly makes it difficult to install the polishing pad to the polishing device. Additionally, heat generated during the polishing is accumulated, possibly resulting in an excessively high polishing temperature. The thickness of the elastic layer may be changed according to the height and the size of the unevenness on the object to be polished, and the thickness of the elastic layer can be outside the range of the above-described values.

Furthermore, after the fibers 12 are installed to the base portion 11, processes like the following may be performed on the surfaces of the fibers 12. That is, a process such as a vapor process, shirring, mercerization, coating, a softening process, a hair-splitting process, and a raising process may be performed on the surfaces of the fibers 12. By performing these processes, a specific function is given to the fibers 12, the surfaces of the fibers 12 are uniformed, the surfaces of the fibers 12 are smoothed, the fibers 12 are softened, and the fibers 12 are compressed.

### (2) Object to be Polished

The shapes of the projection portion 21 and the recessed portion 22 formed on the surface of the object to be polished 2 are not especially limited. The use of the polishing pad of this embodiment can sufficiently polish the parts near the projection portions 21 and the inner surfaces of the recessed portions 22 with various shapes. The examples of the shapes of the projection portion 21 and the recessed portion 22 include a conical shape, a truncated cone shape, a columnar shape, a pyramid shape, a truncated pyramid shape, a prismatic shape, a spherical shape, a hemispherical shape, a needle shape, an irregular shape, and the like.

The sizes of the projection portion 21 and the recessed portion 22 formed on the surface of the object to be polished 2 are not especially limited. The use of the polishing pad of this embodiment can sufficiently polish the parts near the projection portions 21 and the inner surfaces of the recessed portions 22 with various sizes. For example, even when the projection portion 21 or the recessed portion 22 with the size of a projected area of the projection portion 21 or the recessed portion 22 in a vertical projection diagram when the projection portion 21 or the recessed portion 22 is viewed from a view point at a position vertical to the surface of the object to be polished 2 of 0.1 cm² or more, the part near the projection portion 21 or the inner surface of the recessed portion 22 can be sufficiently polished.

The projection portion and the recessed portion of the present invention are limited to the projection portion and the recessed portion with the projected area smaller than the polishing pad used for polishing. That is, there may be a case where a curved surface having a large waviness shape and a large wave formed on the surface of the object to be polished may have the projected area larger than the polishing pad, and the curved surface is not encompassed by the projection portion and the recessed portion of the present invention.

Furthermore, the height of the projection portion 21 and the depth of the recessed portion 22 formed on the surface of the object to be polished 2 are not especially limited. The use of the polishing pad of this embodiment can sufficiently polish the parts near the projection portions 21 with various heights and the inner surfaces of the recessed portions 2 with various depths. For example, the height of the projection portion 21 and the depth of the recessed portion 22 may be 0.1 mm or more, may be 0.5 mm or more, and may be 1 mm or more. Note that the polishing pad of this embodiment is especially preferable with the height of the projection portion 21 or the depth of the recessed portion 22 of 0.5 mm or more.

Thus, with the use of the polishing pad of this embodiment, even with the object to be polished 2 having at least one of the projection portion 21 and the recessed portion 22 with the above-described shapes, sizes, and heights on the surface, the part near the projection portion 21 and the inner surface of the recessed portion 22 in the surface of the object to be polished 2 can be sufficiently polished. Note that the polishing pad of this embodiment is preferably applicable to polish an object to be polished (an object to be polished in which the entire surface has a flat shape) not having a projection portion and a recessed portion on the surface.

The material of the object to be polished is not especially limited and includes elemental silicon, a silicon compound, metal, alloy, metal oxide, a single crystal compound (for example, sapphire and gallium nitride), glass, and the like.

The elemental silicon includes, for example, single-crystal silicon, polycrystalline silicon (polysilicon), and amorphous silicon. The silicon compound includes, for example, silicon nitride, silicon dioxide (for example, an insulating film between silicon dioxide layers formed using tetraethoxysilane (TEOS)), and silicon carbide.

The metal includes, for example, tungsten, copper, aluminum, hafnium, cobalt, nickel, titanium, tantalum, gold, silver, platinum, palladium, rhodium, ruthenium, iridium, osmium, iron, chrome, and magnesium. These metals may be contained in a form of an alloy (for example, a stainless steel) or a metal compound.

The alloyed material is named after metal species as the main component. The main component of the metal and the alloyed material includes, for example, aluminum, titanium, iron, nickel, and copper. The alloyed material includes, for example, an aluminum alloy, a titanium alloy, a stainless steel (the main component is iron), a nickel alloy, and a copper alloy.

The main component of the aluminum alloy is aluminum and further contains at least one kind of, for example, silicon, iron, copper, manganese, magnesium, zinc, and chrome as the metal species different from the metal species of the main component. The content of the metal species other than the aluminum in the aluminum alloy is, for example, 0.1 mass% or more, and more preferably 0.1 mass% or more to 10 mass% or less. The examples of the aluminum alloy include alloy numbers 2000 series, 3000 series, 4000 series, 5000 series, 6000 series, 7000 series, and 8000 series described in H4000 : 2006, H4040: 2006, and H4100: 2006 of the Japanese Industrial Standards (JIS).

The main component of the titanium alloy is titanium and contains, for example, aluminum, iron, and vanadium as an element having Vickers hardness substantially different from that of the metal species as the main component. The titanium alloy contains the element having the Vickers hardness substantially different from that of the metal species as the main component preferably by 3.5 to 30 mass% relative to the titanium. As such titanium alloy, for example, there has been known the types 11 to 23, the type 50, the type 60, the type 61, and the type 80 in the types according to JIS H4600: 2012.

The main component of the stainless steel is iron, and the stainless steel contains, for example, chrome, nickel, molybdenum, and manganese as the element having the Vickers hardness substantially different from that of the metal species as the main component. The stainless steel contains the element having the Vickers hardness substantially different from that of the metal species as the main component preferably by 10 to 50 mass% relative to the iron. As such stainless steel, there has been known, for example, SUS201, 303, 303Se, 304, 304L, 304NI, 305, 305JI, 309S, 310S, 316, 316L, 321, 347, 384, XM7, 303F, 303C, 430, 430F, 434, 410, 416, 420J1, 420J2, 420F, 420C, and 631J1 in type codes according to JIS G4303: 2005.

The main component of the nickel alloy is nickel, and the nickel alloy contains, for example, iron, chrome, molybdenum, and cobalt as the element having the Vickers hardness substantially different from that of the metal species as the main component. The nickel alloy contains the element having the Vickers hardness substantially different from that of the metal species as the main component preferably by 20 to 75 mass% relative to the nickel. As such nickel alloy, there has been known, for example, NCF600, 601, 625, 750, 800, 800H, 825, NW0276, 4400, 6002, and 6022 in the alloy numbers according to JIS H4551: 2000.

The main component of the copper alloy is copper, and the copper alloy contains, for example, iron, lead, zinc, and tin as the element having the Vickers hardness substantially different from that of the metal species as the main component. The copper alloy contains the element having the Vickers hardness substantially different from that of the metal species as the main component preferably by 3 to 50 mass% relative to the copper. As such copper alloy, there has been known, for example, C2100, 2200, 2300, 2400, 2600, 2680, 2720, 2801, 3560, 3561, 3710, 3713, 4250, 4430, 4621, 4640, 6140, 6161, 6280, 6301, 7060, 7150, 1401, 2051, 6711, and 6712 in the alloy numbers according to JIS H3100: 2006.

The main component of the magnesium alloy is magnesium, and the magnesium alloy further contains at least one kind of, for example, aluminum, zinc, manganese, zirconium, and a rare earth element as the metal species different from the metal species of the main component. The content of the metal species other than the magnesium in the magnesium alloy is, for example, 0.3 mass% or more to 10 mass% or less. Examples of the magnesium alloy include the alloy numbers AZ10, 31, 61, 63, 80, 81, 91, and 92 described in H4201: 2011, H4203: 2011, and H4204: 2011 in the Japanese Industrial Standards (JIS) .

The metal oxide is oxide of metal or metalloid or composite oxide of these substances, and includes, for example, one kind or more of the oxide of the metal or the metalloid selected from elements of a third group, a fourth group, and a thirteenth group in the periodic table or a composite oxide of these substances. Specifically, the metal oxide includes silicon oxide (silica), aluminum oxide (alumina), titanium oxide (titania), zirconium oxide (zirconia), gallium oxide, yttrium oxide (yttria), germanium oxide, and the composite oxide of these substances. Among these metal oxides, the silicon oxide, the aluminum oxide (such as corundum), the zirconium oxide, and the yttrium oxide are especially preferable.

The metal oxide included in the object to be polished may be a mixture of a plurality of oxides of metals or metalloids, may be a mixture of a plurality of composite oxides, or may be a mixture of the oxide of metal or metalloid and the composite oxide. The metal oxide included in the object to be polished contains may be a composite material of the oxide of metal or metalloid or the composite oxide and a material of kind other than the substances (for example, metal, carbon, and ceramic).

Furthermore, the metal oxide included in the object to be polished may be in a form such as a single crystal, a polycrystal, a sintered body (ceramic), and the like. When the metal oxide has such form, the object to be polished can be entirely made of the metal oxide. Alternatively, the metal oxide included in the object to be polished may be in a form of an anodic oxidation film formed by performing an anodic oxidation film process on pure metal and an alloy. That is, the metal oxide included in the object to be polished may be oxide produced through oxidation of the metal itself formed on the surface of the metal, like the anodic oxidation film of the pure metal and the alloy.

When the metal oxide has such form, the object to be polished can be partially made of metal oxide and a part other than that may be made of another material. In the case where the metal oxide is an anodic oxidation film, a part of the object to be polished including the surface is made of metal oxide, and a part other than that is made of pure metal or the alloy.

Examples of the anodic oxidation film include a film constituted of aluminum oxide, titanium oxide, magnesium oxide, or zirconium oxide.

The object to be polished may be constituted by forming a film by a film process such as thermal spraying (for example, plasma spraying and flame spraying), plating, chemical vapor deposition (CVD), and physical vapor deposition (PVD) on the surface of a base material of a material (for example, metal, carbon, and ceramic) of a kind different from the metal oxide.

Examples of the film formed by thermal spraying include a metal oxide film constituted of aluminum oxide, zirconium oxide, or yttrium oxide.

Examples of the film formed by plating include a metal film constituted of zinc, nickel, chrome, tin, copper, or an alloy of the substances.

Examples of the film formed by chemical vapor deposition include a ceramic film constituted of silicon oxide, aluminum oxide, or silicon nitride.

Examples of the film formed by physical vapor deposition include a metal film constituted of copper, chrome, titanium, a copper alloy, a nickel alloy, or a ferrous alloy.

### (3) Polishing Method of Object to be Polished

Polishing the object to be polished using the polishing pad of this embodiment can be performed with a polishing device and polish conditions used for usual polishing.

For example, as illustrated in FIG. 3, pressing the surface of the object to be polished 2 on which the projection portion 21 is formed against the napped part 1 of the polishing pad deforms the fibers 12 and concaves a part of the napped part 1, and the polishing pad follows the shape of the projection portion 21. Accordingly, the polishing pad (the fibers 12) contacts the part near the projection portion 21 as well in the surface of the object to be polished 2. Accordingly, the relative movement of the object to be polished 2 to the polishing pad in this state and generating a friction polishes the entire surface of the object to be polished 2 including the part near the projection portion 21.

As illustrated in FIG. 5, pressing the surface of the object to be polished 2 on which the recessed portion 22 is formed against the napped part 1 of the polishing pad deforms the fibers 12 and concaves a part of the napped part 1, and the polishing pad follows the shape of the recessed portion 22. Accordingly, the polishing pad (the fibers 12) contacts the inner surface of the recessed portion 22 as well in the surface of the object to be polished 2. Accordingly, the relative movement of the object to be polished 2 to the polishing pad in this state and generating a friction polishes the entire surface of the object to be polished 2 including the inner surface of the recessed portion 22.

To polish the object to be polished 2 using the polishing pad of this embodiment, a polishing composition containing abrasives, additive, liquid medium, and the like may be interposed between the object to be polished 2 and the polishing pad for polishing.

The kind of the abrasives is not especially limited and includes aluminum oxide, silicon oxide, cerium oxide, zirconium oxide, zircon, titanium oxide, manganese oxide, silicon carbide, boron carbide, carbonize titanium, titanium nitride, silicon nitride, titanium boride, tungsten boride, and the like.

Among them, in terms of ease of acquisition and the cost, aluminum oxide, zirconium oxide, zircon (zircon sand), silicon carbide, and silicon oxide are preferable, and aluminum oxide and silicon oxide are especially preferable.

The average particle diameter of the abrasives is preferably 5 µm or less, more preferably 1 µm or less, further preferably 0.5 µm or less, and especially preferably 0.3 µm or less. There is a tendency that, as the average particle diameter of the abrasives becomes small, the flaws on the surface of the object to be polished after the polishing decrease, the surface roughness becomes excellent, and the surface further smooths. The average particle diameter of the abrasives can be measured by, for example, a dynamic light scattering method, a laser diffraction method, a laser scattering method, and a pore electric resistance method.

Although not limited, a surface roughness Ra of the object to be polished that is polished using the abrasives becomes, for example, 50 nm or less when alumina abrasives are used and 20 nm or less when silica abrasives are used. The surface roughness Ra can be measured using a stylus type and a laser measuring machines.

The concentration of the abrasives in the polishing composition is preferably 45 mass% or less and further preferably 25 mass% or less. The lower the concentration of the abrasives is, the better the dispersibility becomes and the more the cost can be reduced. The concentration of the abrasives in the polishing composition is preferably 2 mass% or more and further preferably 10 mass% or more. The higher the concentration of the abrasives is, the higher the polishing removal rate becomes.

The kind of the additive is not especially limited, for example, an additive such as a pH adjuster, a complexing agent, an etching agent, an oxidant, a water-soluble polymer, an anticorrosive, a chelating agent, a dispersion auxiliary agent, a preservative, and an antifungal agent may be added to the polishing composition as desired.

These various additives are publicly known in many patent literatures and the like as ones that can be usually added to the polishing composition, and the kind and the additive amount of the additive are not especially limited. However, the additive amount when these additives are added is each preferably less than 1 mass% relative to the entire polishing composition and each of which is more preferably less than 0.5 mass%. One kind of these additives may be used alone or two or more kinds may be used together.

### [pH of Polishing composition]

While the pH of the polishing composition is not especially restricted, acidity or alkalinity is preferable. Specifically, pH5 or less is preferable for acidity and pH3 or less is more preferable. PH8 or more is preferable for alkalinity and pH9.5 or more is more preferable.

While the pH can be regulated with acid or the salt as one component of the polishing composition, the use of known acid, base, or salts of these substances other than that also allows regulating pH.

### [pH adjuster]

As the pH adjuster, the known acid, base, or the salts of those substances is applicable. The acid that can be used as the pH adjuster includes inorganic acid and organic acid. The inorganic acid includes, for example, hydrochloric acid, sulfuric acid, nitric acid, hydrofluoric acid, boric acid, carbonic acid, hypophosphorous acid, phosphorous acid, and phosphoric acid. The organic acid includes, for example, formic acid, acetic acid, propionic acid, butyric acid, valeric acid, 2-methylbutyric acid, n-hexanoic acid, 3,3-dimethylbutyric acid, 2-ethylbutyric acid, 4-methylpentanoic acid, n-heptanoic acid, 2-methylhexanoic acid, n-octane acid, 2-ethylhexanoic acid, benzoic acid, glycolic acid, salicylic acid, glyceric acid, oxalic acid, malonic acid, succinic acid, glutaric acid, adipic acid, pimelic acid, maleic acid, phthalic acid, malic acid, tartaric acid, citric acid, lactic acid, diglycolic acid, 2-furancarboxylic acid, 2,5-furandicarboxylic acid, 3-furancarboxylic acid, 2-tetrahydrofuran carboxylic acid, methoxyacetic acid, methoxyphenyl acetic acid, and phenoxyacetic acid.

The base that can be used as the pH adjuster includes amine such as aliphatic amine and aromatic amine, organic base such as quaternary ammonium hydroxide, hydroxide of alkali metal such as potassium hydroxide, hydroxide of alkaline earth metal, ammonia, and the like.

Instead of the above-described acids or in combination with the acids, ammonium salt of the acid and salt such as alkali metal salt may be used as the pH adjuster. Especially, with salt of weak acid and strong base, salt of strong acid and weak base, or salt of weak acid and weak base, a buffer action of pH can be expected, and further with salt of strong acid and strong base, not only the pH but also conductivity are adjustable by the small amount. The additive amount of the pH adjuster is not especially limited, and it is only necessary to adjust appropriately such that the polishing composition becomes the desired pH.

### [Complexing Agent]

Examples of the complexing agent include inorganic acid, organic acid, amino acid, a nitrile compound, and a chelating agent. Specific examples of the inorganic acid include sulfuric acid, nitric acid, boric acid, and carbonic acid. Specific examples of the organic acid include formic acid, acetic acid, propionic acid, butyric acid, valeric acid, 2-methylbutyric acid, n-hexanoic acid, 3,3-dimethylbutyric acid, 2-ethylbutyric acid, 4-methylpentanoic acid, n-heptanoic acid, 2-methylhexanoic acid, n-octane acid, 2-ethylhexanoic acid, benzoic acid, glycolic acid, salicylic acid, glyceric acid, oxalic acid, malonic acid, succinic acid, glutaric acid, adipic acid, pimelic acid, maleic acid, phthalic acid, malic acid, tartaric acid, citric acid, and lactic acid. Organic sulfuric acid such as methanesulfonic acid, ethanesulfonic acid, and isethionic acid are also usable. Instead of the inorganic acid or the organic acid or in combination with the inorganic acid or the organic acid, salt such as alkali metal salt of the inorganic acid or the organic acid may be used. Among these complexing agents, glycine, alanine, malic acid, tartaric acid, citric acid, glycolic acid, isethionic acid, or salts of these substances is preferable.

Examples of the chelating agent include carboxylic acid-based chelating agent such as gluconic acid, amine-based chelating agent such as ethylenediamine, diethylene triamine, and trimethyltetraamine, and a polyaminopolycarboxylic acid-based chelating agent such as ethylenediaminetetraacetic acid, nitrilotriacetic acid, hydroxyethylethylenediamine triacetic acid, triethylenetetraaminehexaacetic acid, and diethylenetriaminepentaacetic acid. Examples of the chelating agent can also include an organic phosphonic acid-based chelating agent such as 2-aminoethylphosphonic acid, 1-hydroxyethylidene-1,1-diphosphonic acid, aminotri(methylenephosphonic acid), ethylenediaminetetrakis(methylenephosphonic acid), diethylenetriaminepenta (methylenephosphonic acid), ethane-1,1-diphosphonic acid, ethane-1,1,2-triphosphonic acid, methane hydroxyphosphonic acid, and 1-phosphonobutane-2,3,4-tricarboxylic acid, phenol derivative, and 1,3-diketone.

### [Etching Agent]

The etching agent to promote dissolution of the object to be polished (for example, the alloyed material) may be further added to the polishing composition as necessary.

Examples of the etching agent include inorganic acid such as nitric acid, sulfuric acid, and phosphoric acid, organic acid such as acetic acid, citric acid, tartaric acid, and methanesulfonic acid, inorganic alkali such as potassium hydroxide and sodium hydroxide, and organic alkali such as ammonia, amine, and quaternary ammonium hydroxide.

### [Oxidant]

The oxidant to oxidize the surface of the object to be polished (for example, the alloyed material) may be further added to the polishing composition as necessary.

Examples of the oxidant include hydrogen peroxide, peracetic acid, percarbonate, urea peroxide, perchlorate, persulfate, nitric acid, and potassium permaganate.

### [Water-Soluble Polymer]

The water-soluble polymer includes, for example, polycarboxylic acid such as polyacrylic acid, polysulfonic acid such as polyphosphonic acid and polystyrene sulfonic acid, polysaccharide such as chitansan gum and sodium alginate, cellulose derivative such as hydroxyethyl cellulose and carboxymethyl cellulose; polyethylene glycol, polyvinyl alcohol, polyvinylpyrrolidone, polyoxyethylene alkyl ether, polyoxyethylene alkyl phenyl ether, sorbitan monooleate, and an oxyalkylene-based polymer having a single kind or a plurality of kinds of oxyalkylene units. Salts of the above-described compounds are also preferably applicable as the water-soluble polymer.

### [Anticorrosive]

The anticorrosive to reduce corrosion of the surface of the object to be polished (for example, the alloyed material) may be further added to the polishing composition as necessary.

Examples of the anticorrosive include amines, pyridines, tetraphenylphosphonium salt, benzotriazoles, triazoles, tetrazoles, and benzoic acid.

### [Dispersion Auxiliary Agent]

The dispersion auxiliary agent to ease redispersion of an aggregate of the abrasives may be further added to the polishing composition as necessary.

Examples of the dispersion auxiliary agent include condensed phosphate such as pyrophosphate and sodium hexametaphosphate.

### [Surfactant]

The surfactant includes nonionic surfactant, anionic surfactant, cationic surfactant, and amphoteric surfactant. The nonionic surfactant includes an ether type, an ether ester type, an ester type, and a nitrogen-containing type. The anionic surfactant includes carboxylate, sulfonate, sulfate ester salt, and phosphoric acid ester salt. The cationic surfactant includes alkylamine salt, aliphatic quaternary ammonium salt, benzalkonium chloride salt, benzethonium chloride, pyridinium salt, and imidazolinium salt. The amphoteric surfactant includes a carboxybetaine type, aminocarboxylate, imidazolinium betaine, lecithin, and alkylamine oxide.

### [Preservative and Antifungal Agent]

The preservative and the antifungal agent may be further added to the polishing composition as necessary.

Examples of the preservative include sodium hypochlorite.

Examples of the antifungal agent include oxazoline such as oxazolidine-2,5-dione.

Furthermore, the polishing composition contains liquid medium as a dispersion medium or a solvent to disperse or dissolve each component. The kind of the liquid medium is not especially limited and includes water, organic solvent, and the like. While one kind may be used alone or two or more kinds may be mixed and used as the liquid medium, containing the water is preferable . From an aspect of reducing hindrance of an action of another component, water that does not contain impurities as much as possible is preferable. Specifically, pure water, ultrapure water, or distilled water from which contaminants are removed through a filter after impurity ion is removed by ion-exchange resin is preferable.

At least one of a previous process and a post-process of a process of polishing using the polishing pad of this embodiment, polishing using a general polishing pad constituted of suede, nonwoven fabric, polyurethane, and the like may be performed. For example, stock polishing may be performed as the polishing at the previous process and final polishing may be performed as the polishing at the post-process. At the previous process of the process of polishing using the polishing pad of this embodiment, the stock polishing may be performed using the polishing pad that includes the napped part where a plurality of fibers with the length of 3 mm or more are napped on the surface of the base portion and the count of fibers is less than 10000 pieces/cm², and fine polishing may be performed using the polishing pad of this embodiment at the subsequent process for mirror finish of the surface of the object to be polished.

The polishing method of this embodiment is more appropriate for a method where polishing is performed while an aqueous polishing composition is continuously supplied and a platen is on the lower side and the object to be polished is on the upper side. From the aspect of productivity, a plurality of pieces of the object to be polished are desirable to be polished in one-time polishing. From the aspect of productivity, the diameter of the platen to which the polishing pad is pasted is preferable to be 300 mm or more and 600 mm or more is further preferable.

Furthermore, a single-surface polishing device, a both-surface polishing device, and the like are applicable to polish the object to be polished using the polishing pad of this embodiment.

The single-surface polishing device includes a holder to hold the object to be polished, one piece of a platen to which the polishing pad is mounted, and a rotation mechanism that rotates the holder and the platen. The sizes of the polishing pad and the platen are larger than that of the obj ect to be polished. After the object to be polished is held to the holder and the polishing pad of this embodiment is mounted to the platen, the object to be polished is brought into contact with the polishing pad while the holder and the platen are rotated by the rotation mechanism. Then, only one surface (that is, a surface facing the polishing pad) can be polished among the plurality of surfaces that the object to be polished has. While polishing the object to be polished using the polishing pad of this embodiment can be performed using not only the single-surface polishing device but also the both-surface polishing device, the hand polisher, a polishing tape, and the like, from the aspect of productivity, the use of the single-surface polishing device or the both-surface polishing device is preferable.

### [Example]

The following describes examples and further specifically describes the present invention with reference to Table 1. Objects to be polished having projection portions on the surfaces were polished using various polishing pads.

Examples 1 to 4 and Comparative Examples 1 to 6 are examples of using a carpet as the polishing pad that includes a napped part where fibers are napped on a surface of a base portion. The kind, the thickness (the diameter), the length, the mass, and the count of the fibers are as described in Table 1.

The polishing pads of Examples 1 to 3 and Comparative Examples 1 and 3 have an elastic layer. That is, the polishing pads of Examples 1 to 3 and Comparative Example 1 and 3 are formed by stacking the elastic layer made of foamed polyurethane on a principal surface on a side opposite to a principal surface on a side on which the fibers are napped among the two principal surfaces that the sheet-shaped base portion has. The thickness of the elastic layer is as described in Table 1. The polishing pads of Example 4 and Comparative Examples 2, 4, 5, and 6 do not have the elastic layer.

**[Table 1]**

| | Fiber | | | | | Elastic layer | Scratch | Ra [nm] | Glossiness | Following capability of polishing pad |
|---|---|---|---|---|---|---|---|---|---|---|
| | Kind | Thickness [µm) | Length [mm] | Mass [g/m²] | Count of pieces [piece/cm²] | Thickness [mm] | | | | |
| Example 1 | Polyester | 16 | 6 | 320 | 19000 | 6 | Excellent | 23 | 1805 | Excellent |
| Example 2 | Polyester | 14 | 6 | 350 | 16600 | 7 | Excellent | 23 | 1811 | Excellent |
| Example 3 | Polyester | 16 | 6 | 200 | 11200 | 5 | Good | 35 | 1788 | Excellent |
| Example 4 | Polyester | 14 | 6 | 350 | 16600 | - | Excellent | 23 | 1801 | Good |
| Comparative example 1 | Polyester | 11 | 4 | 500 | 8420 | 3 | Good | 45 | 1751 | Excellent |
| Comparative example 2 | Polyester | 11 | 4 | 500 | 8420 | - | Good | 45 | 1751 | Good |
| Comparative example 3 | Polyester | 31 | 10 | 550 | 4030 | 3 | Poor | 59 | 1361 | Excellent |
| Comparative example 4 | Polyester | 20 | 18 | 1190 | 8400 | - | Poor | 51 | 1320 | Excellent |
| Comparative example 5 | Nylon | 65 | 7 | 550 | 3200 | - | Poor | 72 | 1261 | Good |
| Comparative example 6 | Wool | 34 | 9 | 690 | 2800 | - | Poor | 65 | 1295 | Excellent |

Next, the following describes the objects to be polished used. The object to be polished has a plate shape with a length of 60 mm, a width of 60 mm, and a thickness of 10 mm, and the material is an aluminum alloy of the alloy number 7000 series. One piece of an approximately column-shaped projection portion with a diameter of 10 mm and a height of 1 mm is formed on the plate surface of the object to be polished. The projection portion is formed at a part near one corner portion among four corner portions of the plate surface.

The plate surfaces on the sides on which the projection portions were formed of the objects to be polished were each polished using the polishing pads of Examples 1 to 4 and Comparative Examples 1 to 6. A slurry polishing composition was interposed between the object to be polished and the polishing pad in the polishing. Water was added to a mixture containing colloidal silica with the particle diameter of 50 nm by 40 mass%, polyoxyethylene alkyl ether by 0.45 mass%, and potassium nitrate by 0 . 5 mass% and the remnant being water to be diluted double by the volume ratio, thus producing this polishing composition.

The polish conditions are as follows.

### (Polish conditions)

Polishing device: single-surface polishing device (a diameter of a platen: 380 mm)
Polishing load: 18.1 kPa (185 gf/cm²)
Rotation speed of platen: 90 min⁻¹
Platen rotation speed (linear velocity) : 71.5 m/minute Polishing time: 20 minutes
Supply speed of polishing composition: 40 mL/minute

When the polishing was finished, the surface (the plate surface) of the object to be polished was observed by visual check and whether a part not sufficiently polished was present on the surface of the object to be polished or not was checked. When the part not sufficiently polished was present at a part near the projection portion in the surface of the objects to be polished, a distance between the sufficiently polished part and the base end portion of the projection portion was measured. Based on the following criteria, following capability (deformability of the polishing pad) of the polishing pad to the shape of the projection portion was evaluated from the measurement results (the distances).

That is, when the distance between the sufficiently polished part and the base end portion of the projection portion was 3 mm or more, it was evaluated that the following capability of the polishing pad was poor, and Table 1 describes the evaluation by Poor. When the distance was 2 mm or more to less than 3 mm, it was evaluated that the following capability of the polishing pad was good, and Table 1 describes the evaluation by Good. Furthermore, when the distance was less than 2 mm, it was evaluated that the following capability of the polishing pad was especially good, and Table 1 describes the evaluation by Excellent.

As apparent from Table 1, Examples 1 to 4 exhibited the good following capability of the polishing pad, and the polishing was sufficiently performed up to the part near the projection portion in the surface of the object to be polished. Especially, it can be seen from the comparison between Example 2 and Example 4 that the one including the elastic layer has the good following capability of the polishing pad and the polishing is sufficiently performed up to the part further near the projection portion in the surface of the object to be polished.

The scratch, the surface roughness, and the glossiness of the surface (the polished surface) of the object to be polished where the polishing had been finished were measured. The surface of the object to be polished was observed under a fluorescent light illumination by visual check, the count of linear flaws was counted, and the evaluation of the scratch was performed based on the following criteria. That is, the scratch was evaluated as poor with the count of linear flaws in excess of 30, and Table 1 describes the evaluation by Poor. The scratch was evaluated as good with the count of linear flaws of 6 to 30, and Table 1 describes the evaluation by Good. Furthermore, the scratch was evaluated as especially good with the count of linear flaws of 0 to 5, and Table 1 describes the evaluation by excellent.

The surface roughness (arithmetic mean roughness Ra) of the surface of the object to be polished was measured using a contactless surface shape measuring machine (the laser microscope VK-200 manufactured by KEYENCE CORPORATION) . The measured area size was set to 1012 µm × 5400 µm. Table 1 describes the results.

The glossiness of the surface of the object to be polished was measured using a mirrored surface glossiness meter (Multi Gloss 268Puls manufactured by KONICA MINOLTA, INC.). Describing in detail, the glossiness was measured at any three points on a diagonal line on the surface of the square-shaped object to be polished to obtain an average value of gloss values (20 degree) at each measured point. Table 1 describes the results.

As can be seen from Table 1, since Examples 1 to 4 had the count of fibers of 10000 pieces/cm² or more, the scratch, the surface roughness Ra, and the glossiness were good. In contrast to this, since Comparative Examples 1 to 6 had the count of fibers of less than 10000 pieces/cm², the scratch, the surface roughness Ra, and the glossiness were inferior to those of Examples 1 to 4.

As can be seen from Table 1, since Examples 1 to 4 had the thickness of the fibers of 20 µm or less, the scratch and the glossiness were good. In contrast to this, since Comparative Examples 3, 5, and 6 had the thickness of the fibers in excess of 20 µm, the scratch and the glossiness were inferior to those of Examples 1 to 4.

### Reference Signs List

- 1: napped part
- 2: object to be polished
- 11: base portion
- 12: fiber
- 21: projection portion
- 22: recessed portion

## Claims

1. A polishing pad comprising
a base portion, and
a napped part in which a plurality of fibers with a length of 3 mm or more are napped on a surface of the base portion, wherein
a count of the fibers is 10000 pieces/cm² or more.

2. The polishing pad according to claim 1, comprising
a multilayer structure including an elastic layer made of an elastic body formed in an opposite side of a side of the base portion in which the fibers are napped.

3. The polishing pad according to claim 1 or claim 2, wherein
the fibers have a thickness of 20 µm or less.

4. The polishing pad according to any one of claim 1 to claim 3, wherein
the fibers have a mass of 200 g/m² or more.

5. The polishing pad according to any one of claim 1 to claim 4 used for polishing an object to be polished containing a metal or a metal oxide material.

6. The polishing pad according to any one of claim 1 to claim 4 used for polishing an object to be polished having a surface with at least one of a projection portion and a recessed portion.

7. The polishing pad according to any one of claim 1 to claim 6 used for polishing using a polishing composition containing abrasives with an average particle diameter of 0.5 µm or less and a water.

8. The polishing pad according to any one of claims 1 to claim 7 used for a single-surface polishing device, the single-surface polishing device including a holder, a platen to which the polishing pad is mounted, and a rotation mechanism, the holder holding the object to be polished, the rotation mechanism rotating the holder and the platen, the single-surface polishing device causing the object to be polished to contact the polishing pad to polish only one surface among a plurality of surfaces that the object to be polished has.

9. A polishing method comprising
polishing an object to be polished using the polishing pad according to any one of claim 1 to claim 8.

10. A polishing method comprising
polishing an object to be polished using the polishing pad according to any one of claim 1 to claim 8 and a polishing composition, the polishing composition containing abrasives with an average particle diameter of 0.5 µm or less and water.

11. The polishing method according to claim 10, wherein
the object to be polished contains a metal or a metal oxide material.

12. The polishing method according to claim 10, wherein
the object to be polished has a surface with at least one of a projection portion and a recessed portion.

13. The polishing method according to any one of claim 10 to claim 12, further comprising:
using a single-surface polishing device, the single-surface polishing device including a holder, a platen to which the polishing pad is mounted, and a rotation mechanism, the holder holding the object to be polished, the rotation mechanism rotating the holder and the platen, and
causing the object to be polished to contact the polishing pad to polish only one surface among a plurality of surfaces of the object to be polished.
